Europäisches Patentamt

European Patent Office

Office européen des brevets

(11) Publication number: **0 126 184**
A2

# EUROPEAN PATENT APPLICATION

(21) Application number: **83112699.0**

(22) Date of filing: **16.12.83**

(51) Int. Cl.³: **H 01 L 27/02**

(30) Priority: **23.12.82 US 452532**

(43) Date of publication of application: **28.11.84**
**Bulletin 84/48**

(84) Designated Contracting States: **DE FR GB NL**

(71) Applicant: **MOTOROLA, INC., 1303 East Algonquin Road, Schaumburg, Illinois 60196 (US)**

(72) Inventor: **Meyer, Charles S., 2307 El Camino Circle, Tempe Arizona 85282 (US)**

(74) Representative: **Ibbotson, Harold, Motorola Ltd Jays Close Viables Industrial Estate, Basingstoke Hants RG22 4PD (GB)**

(54) Input protection circuit and bias method for scaled CMOS devices.

(57) An integrated circuit and method including a protection circuit (70) for an input to a CMOS device formed on a substrate (12) of a given impurity type has a resistive region (20) of an opposite impurity type to the substrate (12) formed therein, the region (20) having input (46) and output (48) connections thereto. A well (22) of the opposite impurity concentration is also formed in the substrate (12), the well (22) being connected to an electrical ground with respect to a first supply voltage lead (54) to the CMOS device. The first supply voltage lead (54) is electrically isolated from the substrate (12). An area (24) of the given impurity type is formed in the well (22), the area (24) and the output (48) connection being electrically common with the CMOS device input. Finally, a second supply voltage lead (60) is electrically connected to the substrate (12) for biasing the substrate to a second supply voltage level exceeding a first supply voltage level.

## INPUT PROTECTION CIRCUIT AND BIAS METHOD
## FOR SCALED CMOS DEVICES

### Background of the Invention

The present invention relates generally to the field of CMOS input circuits and bias methods for protection against input voltage swings exceeding a given supply voltage level in normal operation while retaining conventional protection against static discharge damage. More specifically, the circuit and method of the present invention is of a special applicability to scaled CMOS devices.

Scaled CMOS devices, those having a gate length on the order of 1.25 microns or less, require a reduced power supply for proper operation. That is, as channel lengths have decreased, a concomitantly reduced power supply voltage level is mandated in order to avoid excessive drain voltage reduction of the short-channel device threshold voltage. However, such a reduced supply level (in the 3.0 volt range) prevents acceptance of more conventional 5 volt input logic swings when conventional CMOS input protection structures are used.

Commercial and military standardization groups appear to be settling on 3.3 volts as the supply voltage for future scaled VLSI circuits. Moreover, it is often considered necessary that such circuits be able to handle up to 5.0 volt input logic swings. This requirement presents a challenging problem when applied to the aforementioned scaled CMOS devices. One reason for the capability of handling such input logic levels is that it may be desirable for such scaled CMOS chips to interface with earlier-generation bipolar and MOS chips with their greater output voltage swings. However, with the 3.3 volt $V_{CC}$ supply connected to the N-type substrate, as is conventional in CMOS technology, the use of a PN diode to the substrate in the input protection circuitry would be precluded.

As a possible solution to this problem, it is possible by design to externally insure that the scaled CMOS systems themselves see only 3.3 volt inputs. Alternatively, the input protection circuit to the scaled CMOS devices can be changed so that the aforementioned PN diodes are omitted. Still further, an N-well approach might be used with separate 5.0 volt wells on the inputs and outputs while using 3.3 volt wells internally. In implementing any of these approaches, numerous and sometimes undesirable compromises are necessary with respect to increase circuit complexity and degraded circuit operation.

Further complications in implementation of the scaled CMOS technology include the fact that P channel transistors, due to their deeper junctions, are more susceptible to undesirable short channel effects than are N channel transistors. Additionally, it is also well known that CMOS devices are generally susceptible to latchup due to parasitic SCR action.

It is therefore an object of the present invention to provide an improved input protection circuit and bias method for scaled CMOS devices.

Embodiments of the present invention may provide; an improved input protection circuit and bias method for scaled CMOS devices which accepts input logic swings in excess of the internal supply voltage level;

an improved input protection circuit and bias method for scaled CMOS devices which utilizes conventional power supply voltage levels;

an improved input protection circuit and bias method for scaled CMOS devices which retains PN diodes for circuit input protection;

an improved input protection circuit and method for scaled CMOS devices which allows the retention of a P-well (N-type substrate) CMOS approach while increasing P channel active device threshold voltage, reducing junction capacitance and decreasing undesirable short channel length leakage effects;

an improved input protection circuit and method for scaled CMOS devices which greatly reduces latchup tendancy due to parasitic SCR action;

## Summary of the Invention

The foregoing object is achieved in the present inventio wherein an integrated circuit includes a protection circuit for an input to a CMOS device formed on a substrate of a given inpurity type including a resistive region of an opposite impurity type to the substrate formed therein, the region having input and output connections thereto. A well of the opposite inpurity concentration is formed in the substrate and displaced from the resistive region, the well being connected to an electrical ground with respect to a first supply voltage lead to the CMOS device. The first supply voltage lead is electrically isolated from the substrate for receiving a first supply voltage level. An area of the given impurity type is formed in the well, the area and the output connection of the resistive region being electrically common with the CMOS device input. Finally, a second supply voltage lead is electrically connected to the substrate for biasing the substrate to a second supply voltage level exceeding the first supply voltage level. In combination, the circuit is operative such that an input voltage swing in excess of the first supply voltage level may be applied to the inpu connection to the resistive region to operate the CMOS device.

Also provided is a method for adapting a CMOS device having an input voltage swing in excess of a first supply voltage level electrically isolated from a substrate of a given impurity type including the CMOS device which includes the step of firstly forming a resistive region of an opposite impurity type to the substrate in the substrate. Input and output connections are thereafter provided to the resistive region. A well of the opposite impurity type is formed in the substrate displaced from the resistive region. The well is then grounded with respect to the first supply voltage level. An area of the given impurity type is disposed within the well. The area and the output connection to an input of the CMOS device are thereupon electrically connected. Finally, the substrate is biased by application of a second supply voltage level in excess of the first supply voltage level.

Brief description of the Drawings

The above-mentioned and other features and objects of the invention and the manner of attaining them will become more apparent, and the invention itself will be best understood by reference to the following description of an embodiment of the invention taken in conjunction with the accompanying drawings, wherein:

FIG. 1a is a simplified cross-sectional view of a portion of an integrated circuit including a conventional input protection circuit to a CMOS inverter having the substrate biased to the supply voltage level applied to the source of the inverter load device;

FIG. 1b is a schematic representation of that portion of the circuit illustrated in FIG. 1a;

FIG. 2a is a simplified cross-sectional view of a portion of an integrated circuit according to the present invention illustrating an improved input protection circuit to a CMOS inverter having the substrate biased to a supply voltage level in excess of the supply voltage level applied to the source of the inverter load device;

FIG. 2b is a schematic representation of that portion of the circuit illustrated in FIG. 2a; and

FIG. 2c is a simplified representation illustrating how a potentially active parasitic SCR structure potentially existing in the structure of FIG. 1a is less likely to become active in the embodiment of FIG. 2a.

## Description of a Preferred Embodiment

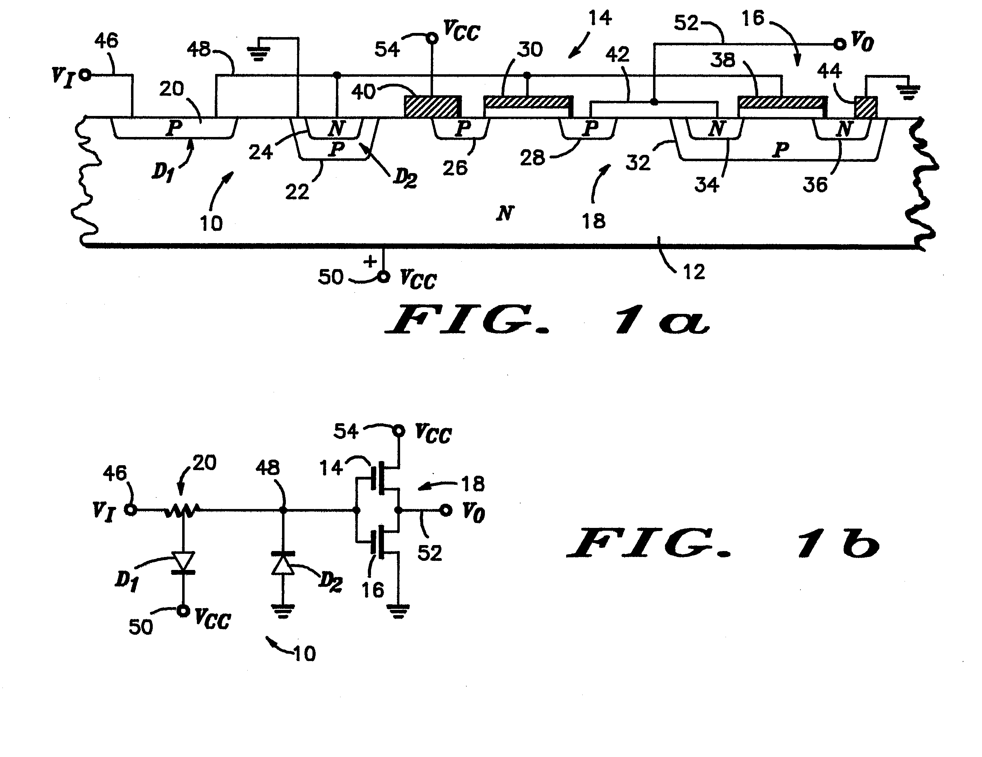

Referring now to FIGS. 1a and 1b, a conventional input protection circuit 10 to a conventional CMOS inverter 18 is shown formed on a common substrate 12. CMOS inverter 18 comprises a P channel transistor 14 and a series connected N channel transistor 16.

Conventional input protection circuit 10 includes a diffused resistor 20 formed in substrate 12. The PN junction formed at the interface of diffused resistor 20 and substrate 12 forms a diode $D_1$. An additional diode $D_2$ is formed at the interface of N region 24 formed within P well 22 which is in turn formed within substrate 12. P well 22 is connected to circuit ground while N region 24 is connected to the common gates of P channel transistor 14 and N channel transistor 16. Additionally, N region 24 is electrically connected via input line 48 to diffused resistor 20. Diffused resistor 20 has as its input an input logic swing appearing on $V_I$ line 46.

P channel transistor 14 comprises a P type source 26 and laterally spaced P type drain 28. Source 26 is connected to a supply voltage applied on $V_{CC}$ line 54 through drain/substrate contact 40. Source/substrate contact 40 also supplies the supply voltage level appearing on $V_{CC}$ line 54 to substrate 12.

N channel transistor 16 is formed within a P tub 32 formed within substrate 12. N channel transistor 16 includes an N type drain 34 and laterally spaced N type source 36. Drain 34 is connected to drain 28 of P channel transistor 14 by connection 42. Source 36 and P tub 32 are connected to circuit ground through source/tub contact 44. Gate electrode 30 of P channel transistor 14 and gate electrode 38 of N channel transistor 16 are electrically common and connected to input line 48. The output of CMOS inverter 18 appears on $V_O$ 52 connected to drain 28 of P channel transistor 14 and drain 34 of N channel transistor 16 as electrically connected by connection 42.

As shown, substrate 12 of conventional input protection circuit 10 is biased to the supply voltage appearing on $V_{CC}$ line 54 through source/substrate contact 40 as well as by an independent substrate bias point 50. Thus, diode $D_1$ has its cathode connected to the supply voltage level $V_{CC}$.

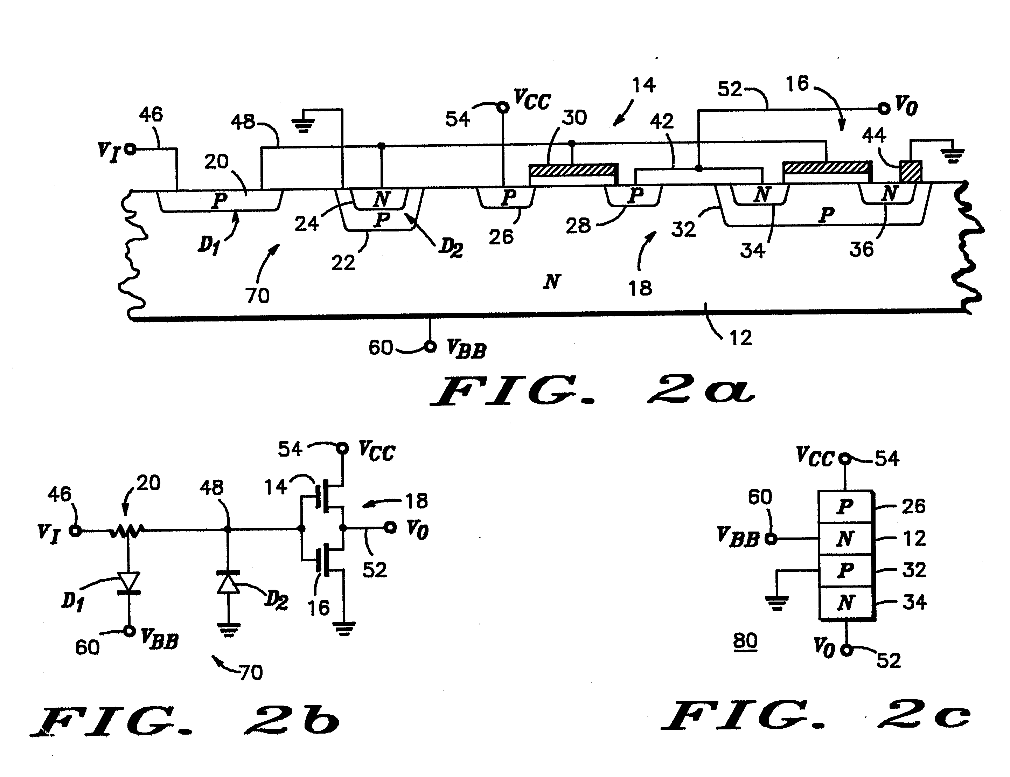

Referring additionally now to FIGS. 2a, 2b and 2c, an improved input protection circuit 70 is shown. In the description of the improved input protection circuit 70 of FIGS. 2a, 2b and 2c, common structure to that appearing in FIGS. 1a and 1b is similarly numbered and the previous description thereof shall suffice for that of improved input protection circuit 70.

As illustrated, $V_{CC}$ line 54 is connected directly to source 26 of P channel transistor 14, source/substrate contact 40 having been eliminated. Concomitantly, substrate bias point 50 of conventional input protection circuit 10 has been replaced with $V_{BB}$ line 60 in improved input protection circuit 70. Thus, the supply voltage level appearing on $V_{CC}$ line 54 is not applied to substrate 12 in improved input protection circuit 70. Rather, a second supply voltage level appearing on $V_{BB}$ line 60 biases substrate 12. Therefore, diode $D_1$ has its cathode connected to a supply voltage $V_{BB}$ as opposed to

$V_{CC}$. For this reason, the potentially parasitic SCR device shown in FIG. 2c has a supply voltage $V_{BB}$ exceeding that of supply voltage level $V_{CC}$ applied to substrate 12, whereby latchup tendency of the potentially parasitic SCR 80 is effectively reduced.

In the example illustrated, if $V_0$ goes below circuit ground, the PN junction formed at the interface of P tub 32 and drain 34 can become forward biased. In the CMOS inverter 18 of FIGS. 1a and 1b, with $V_{BB}$ equal $V_{CC}$, IR drops can forward bias the PN junction formed at the interface of source 26 and substrate 12 resulting in parasitic SCR latchup. However, in the CMOS inverter 18 of FIGS. 2a, 2b and 2c, since $V_{BB}$ is greater than $V_{CC}$, it is much more difficult for the PN junction formed at the interface of source 26 with substrate 12 to become forward biased.

With the improved input protection circuit 70 of FIGS. 2a, 2b and 2c it can be seen that an input signal $V_I$ can't go more positive than one diode drop above the level of $V_{BB}$ without turning on diode $D_1$. Using the conventional input protection circuit 10 of FIGS. 1a and 1b, it can be seen that diode $D_1$ will turn on whenever the input signal $V_I$ exceeds the level of $V_{CC}$ by one diode drop. In scaled CMOS devices, $V_{CC}$ is conventionally 3.3 volts and input signals $V_I$ in excess of 3.3 plus approximately 0.6 volts cannot be utilized.

It has also been found in fabricating scaled CMOS devices having a gate length of approximately 1.25 microns, that the P channel transistor 14 is more prone to suffering excessive leakage current than N channel transistor 16. By biasing substrate 12 by means of $V_{BB}$ line 60 to a level of approximately five volts with respect to a $V_{CC}$ level of about three volts, the problem of excess leakage current is essentially solved. A final advantage is that the increased substrate 12 bias level reduces parasitic junction capacitance existing at source 26 and drain 28 of P channel transistor 14.

In fabricating the improved input protection circuit 70 of the present invention, an additional supply pin must be provided but this is only a mild penalty in view of the large pin count envisioned for VLSI circuits. (Proper sequencing of the supplies is necessary, however, with $V_{BB}$ always greater than or equal to $V_{CC}$.) Tiedowns for applying the $V_{BB}$ supply can be spaced further apart due to its larger magnitude than that of $V_{CC}$ levels thus easing any potential difficulty in the routing of two separate supplies. Additionally, while the foregoing example has illustrated improved input protection circuit 70 in conjunction with P tub (N substrate) technology, it will also be apparent that N tub (P substrate) technology could be utilized with appropriate biasing of the N tubs although supply routing becomes more difficult due to the necessity of separately contacting each N-tub region.

What has been provided, therefore, is an improved input protection circuit and bias method for scaled CMOS devices which accepts input logic swings in excess of the internal supply voltage level. The present invention also provides for scaled CMOS devices which can utilize conventional power supply voltage levels. Further, the improved input protection circuit and bias method of the present invention retains PN diodes for circuit input protection and also greatly reduces the possibility of latchup due to parasitic SCR action. Still further, the present invention allows for the retention of a P well (N type substrate) CMOS approach while increasing P channel active device threshold, reducing junction capacitance and decreasing undesirable short channel length leakage effects.

Claims

1.    An input protection circuit (70) for an input to an integrated circuit CMOS device formed on a substrate (12) of a given impurity type comprising:

a resistive region (20) of an opposite impurity type to said substrate formed in said substrate, said region having input (46) and output (48) connections thereto;

a well (22) of said opposite impurity concentration formed in said substrate and displaced from said resistive region (20), said well (22) being connected to an electrical ground with respect to a first supply voltage lead (54) to said CMOS device, said first supply voltage lead (54) being electrically isolated from said substrate (12) for receiving a first supply voltage level;

an area (24) of said given impurity type formed in said well (22), said area (24) and said output (48) connection of said resistive region (20) being electrically common with said CMOS device input; and

a second supply voltage lead (60) electrically connected to said substrate (12) for biasing said substrate (12) to a second supply voltage level exceeding said first supply voltage level

whereby an input voltage swing in excess of said first supply voltage level may be applied to said input (46) connection to said resistive region (20) to operate said CMOS device.

2.    The input protection circuit of claim 1 wherein said CMOS device comprises an inverter (18).

3.    The input protection circuit of claim 1 wherein said given impurity type is N type semiconductor material.

4. The input protection circuit of claim 1 wherein said first supply voltage level is substantially 3.3 volts.

5. The input protection circuit of claim 1 wherein said second supply voltage level is substantially 5.0 volts.

6. The input protection circuit of claim 5 wherein said input voltage swing is substantially 5.0 volts.

7. A bias method for a scaled CMOS device having an input voltage swing in excess of a first supply voltage level electrically isolated from a substrate (12) of a given impurity type including said CMOS device comprising the steps of:

firstly forming a resistive region (20) of an opposite impurity type to said substrate (12) in said substrate (12);

providing input (46) and output (48) connections to said resistive region;

secondly forming a well (22) of said opposite impurity type in said substrate (12) displaced from said resistive region (20);

electrically grounding said well (22) with respect to said first supply voltage level;

disposing an area (24) of said given impurity type within said well (22);

electrically connecting said area (24) and said output (48) connection to an input of said CMOS device; and

biasing said substrate (12) by application of a second supply voltage level in excess of said first supply voltage level.

8. The bias method of claim 7 wherein said step of firstly forming is carried out using P type semiconductor material.

9. The bias method of claim 7 wherein said step of biasing said substrate (12) is carried out by means of a second supply voltage level of substantially 5.0 volts.

10. The bias method of claim 7 wherein said step of biasing said substrate (12) is carried out by means of a first supply voltage level of substantially 3.3 volts.

FIG. 1a

FIG. 1b

1/2

0126184

FIG. 2a

FIG. 2b

FIG. 2c